# EUROPEAN PATENT APPLICATION

(11) **EP 2 466 663 A1**
(43) Date of publication of application: **20.06.2012**
(21) Application number: 10808070.6
(22) Date of filing: 02.08.2010
(51) Int. Cl.: H01L 51/42

(54) **PHOTOELECTRIC CONVERSION ELEMENT AND MANUFACTURING METHOD THEREFOR**

(30) Priority: 12.08.2009 JP 2009187357
(71) Applicant: Kuraray Co., Ltd., Okayama 710-0801 (JP)
(72) Inventor: TAZAKI, Go, Tsukuba-shi Ibaraki 305-0841 (JP); FUKUDA, Motohiro, Tsukuba-shi Ibaraki 305-0841 (JP); OHGI, Hiroyuki, Kurashiki-shi Okayama 710-0801 (JP); FUJITA, Akio, Kurashiki-shi Okayama 710-0801 (JP)
(74) Representative: Vossius & Partner
(86) International application number: PCT/JP2010/004870
(87) International publication number: WO 2011/018884

(57) **Abstract**

A photoelectric conversion device according to the present invention includes, between a pair of electrodes, an electron donor layer having an interdigitated shape in cross section comprising a stripe-like part in cross section and a base, a plurality of strip-like parts in cross section extending in a direction intersecting electrode main surfaces being formed at intervals in the stripe-like part in cross section; and an electron acceptor layer having an interdigitated shape in cross section comprising a stripe-like part in cross section and a base, a plurality of strip-like parts in cross section extending in a direction intersecting the electrode main surfaces being formed at intervals in the stripe-like part in cross section, the photoelectric conversion device further including an active layer in which the plurality of strip-like parts in cross section of the electron donor layer and the plurality of strip-like parts in cross section of the electron acceptor layer are alternately joined. A stripe width a of the stripe-like part in cross section of the electron donor layer and a stripe width b of the stripe-like part in cross section of the electron acceptor layer are both 5 to 100 nm. When a=b, a thickness c of the active layer is twice to 40 times as large as a (=b). When a≠b, the thickness c of the active layer is twice or more of one of a and b which is smaller and 40 times or less of one of a and b which is larger.

## Description

### Technical Field

The present invention relates to a photoelectric conversion device and a method of manufacturing the same.

### Background Art

These days, the problem of global warming has increased public awareness to environmental issues, and much attention has been given to photovoltaic power generation as an alternative energy to oil and a photoelectric conversion device used for it.
A photoelectric conversion device which has currently been put to practical use for photovoltaic power generation is of inorganic semiconductor type including a crystalline silicon and an amorphous silicon. The problems in such a photoelectric conversion device are that it requires enormous energy and cost in the manufacturing process. Accordingly, there has been an increase in research and development of a photoelectric conversion device using an organic material that can be manufactured with lower energy and lower cost.

The organic material itself is inexpensive and it is easily possible to increase an area of the photoelectric conversion device and to achieve a continuous process since the photoelectric conversion device can be manufactured in atmospheric pressure. Thus, it is considered that the photoelectric conversion device can be manufactured with lower energy and lower cost.
A photoelectric conversion device in which an electron donor layer (p layer) and an electron acceptor layer (n layer) are separately formed and the electron donor layer and the electron acceptor layer are coupled in plane tends to have low photoelectric conversion efficiency. Therefore, in recent years, a bulk hetero junction photoelectric conversion device has been researched and developed. In the bulk hetero junction photoelectric conversion device, solution in which an electron donating material and an electron accepting material are mixed is applied, or the electron donating material and the electron accepting material are co-deposited.

In an organic photoelectric conversion device, among excitons that are generated, only the exciton that has reached a p/n junction interface between the electron donor layer and the electron acceptor layer is involved in charge separation. The distance in which the exciton reaches a charge separation interface (hereinafter referred to as an "exciton diffusion length") is considered to be 50 nm or less, although it varies depending on chemical constitution or purity of the material. Accordingly, when there exists a junction interface between the electron donor layer and the electron acceptor layer for each distance of about twice the exciton diffusion length at intervals, and the electrode is arranged in a direction that is substantially perpendicular to the direction of the junction interface, it may be considered that the exciton which is subjected to charge separation increases and the photoelectric conversion efficiency is improved.

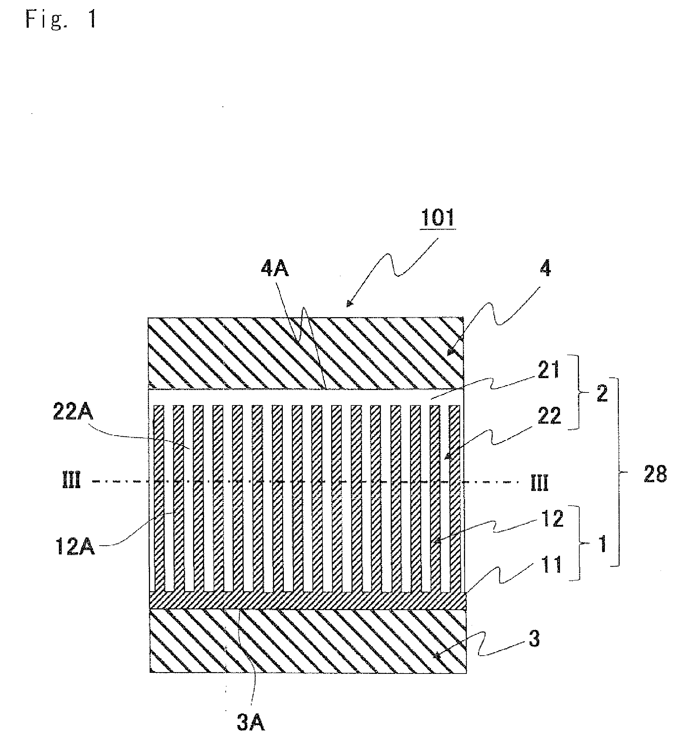

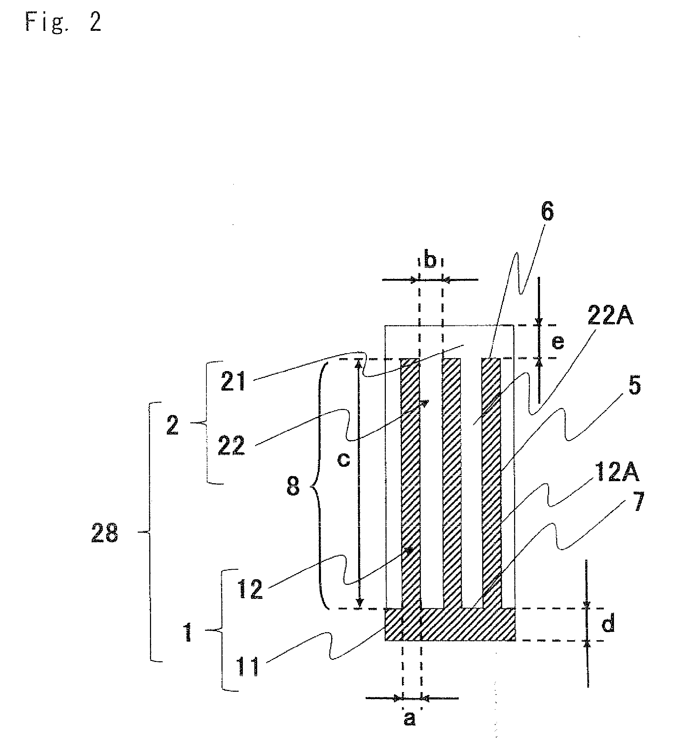

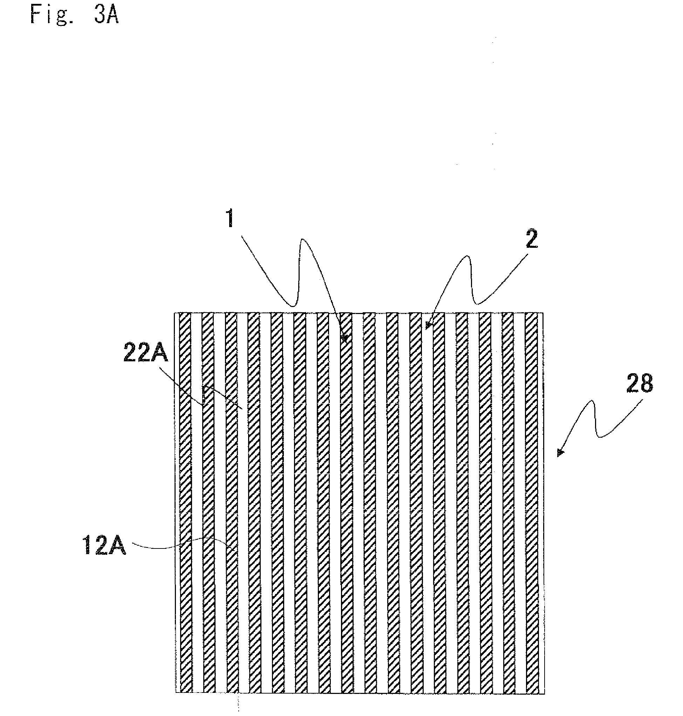

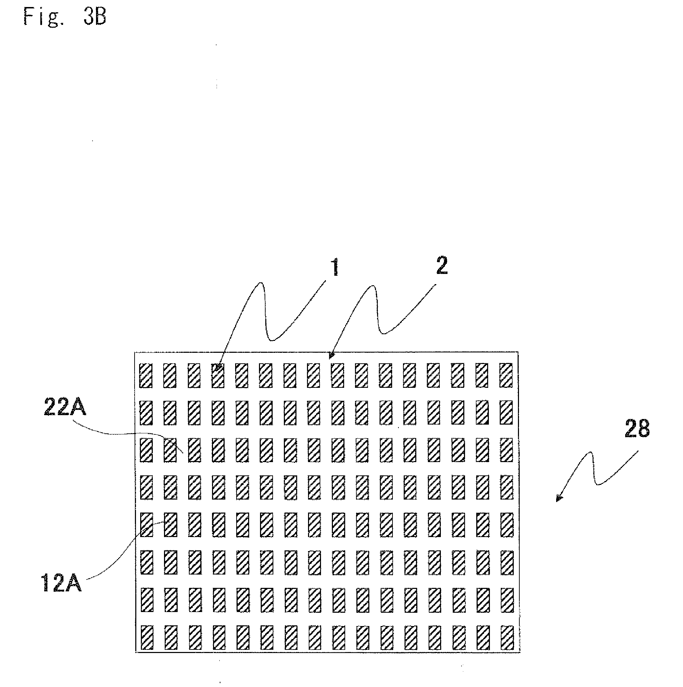

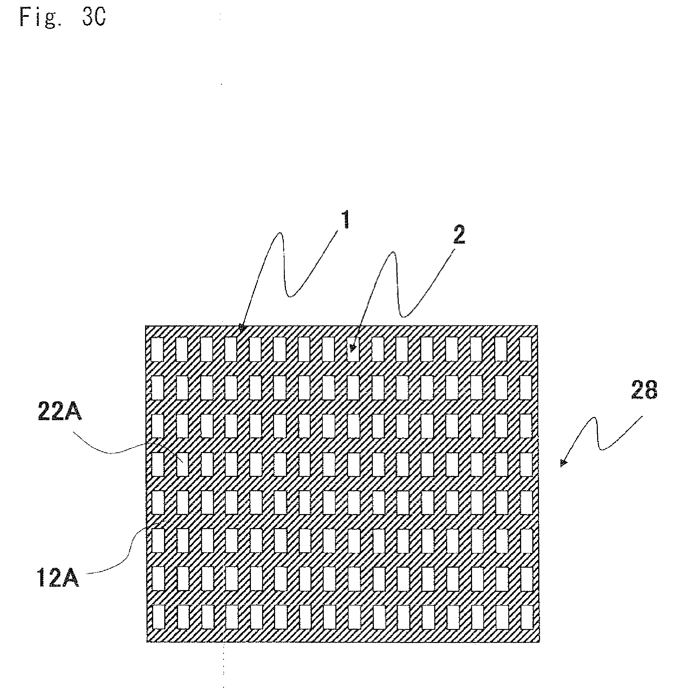

According to a patent literature 1, a superlattice is manufactured by laminating organic semiconductor films. Then, the cross-sections are cut to obtain upright superlattice devices, thereby increasing an interfacial area between an electron donor layer and an electron acceptor layer (Claim 1, Fig. 1 and the like).
A patent literature 2 manufactures a hetero junction device by various methods including a bulk hetero junction manufacturing method which is similar to a related method to increase an interfacial area between an electron donor layer and an electron acceptor layer (Claims 4 and 5, Figs. 1 to 8 and the like).
A patent literature 3 suggests a photoelectric conversion device, in which microphase separation is performed on a block copolymer composed of an organic semiconductor to increase an interfacial area between an electron donor layer and an electron acceptor layer, whereby the photoelectric conversion device has excellent charge separation ability (Claim 1, Figs. 2 and 3 and the like).
A patent literature 4 suggests a manufacturing method of a photoelectric conversion device, in which irregularities are formed on a surface of an organic semiconductor to increase an interfacial area between an electron donor layer and an electron acceptor layer (Claims 1 to 3 and the like).

### Citation List

### Patent Literature

**PTL 1:** Japanese Patent No. 3886431
**PTL 2:** Japanese Unexamined Patent Application Publication No. 2003-298152
**PTL 3:** Japanese Patent No. 4126019
**PTL 4:** Japanese Unexamined Patent Application Publication No. 2008-141103

### Summary of Invention

### Technical Problem

However, since one electrode contacts both of the electron donor layer and the electron acceptor layer in the patent literatures 1 to 3, some problems may occur including degradation of rectification and high possibility of short-circuit.

The problem in the patent literature 4 is that, since only the irregular shape having a low ratio of the height and the width of the irregularities (=aspect ratio) is suggested, the substantial increase in the interfacial area between the electron donor layer and the electron acceptor layer is small, and the degree of improvement of the photoelectric conversion efficiency is small. Further, the patent literature 4 discloses in the paragraph 0026 that "the pitches of the irregularities are preferably fine, e.g., in the order of submicron". The patent literature 4 discloses that the irregular shape having pitches of hundreds of µm, which is greatly larger than the exciton diffusion length is preferably used, and it does not consider the influence given to the photoelectric conversion efficiency by the relation between the exciton diffusion length and the distance between the interfaces. Accordingly, the patent literature 4 does not sufficiently indicate a method to improve photoelectric conversion efficiency.

The present invention has been made in order to solve the aforementioned problems, and aims to provide a photoelectric conversion device which exhibits excellent charge separation and photoelectric conversion efficiency, with high rectification and suppressed short-circuit, and a method of manufacturing the same.

### Solution to Problem

A photoelectric conversion device according to the present invention includes, between a pair of electrodes arranged so that electrode main surfaces of the electrodes are opposed to each other, an electron donor layer having an interdigitated shape in cross section including a stripe-like part in cross section and a base, a plurality of strip-like parts in cross section extending in a direction intersecting the electrode main surfaces being formed at intervals in the stripe-like part in cross section, the base formed on a side of one of the electrodes of the stripe-like part in cross section and connecting the plurality of strip-like parts in cross section; and an electron acceptor layer having an interdigitated shape in cross section including a stripe-like part in cross section and a base, a plurality of strip-like parts in cross section extending in a direction intersecting the electrode main surfaces being formed at intervals in the stripe-like part in cross section, the base formed on a side of the other one of the electrodes of the stripe-like part in cross section and connecting the plurality of strip-like parts in cross section, the photoelectric conversion device further including an active layer in which the plurality of strip-like parts in cross section of the electron donor layer and the plurality of strip-like parts in cross section of the electron acceptor layer are alternately joined, in which a stripe width of the stripe-like part in cross section of the electron donor layer and a stripe width of the stripe-like part in cross section of the electron acceptor layer are both 5 nm or larger and 100 nm or smaller, a thickness of the active layer is twice or more and 40 times or less of the stripe width when the stripe width of the electron donor layer and the stripe width of the electron acceptor layer are the same, and a thickness of the active layer is twice or more of one of the stripe width of the electron donor layer and the stripe width of the electron acceptor layer which is smaller and 40 times or less of one of the stripe width of the electron donor layer and the stripe width of the electron acceptor layer which is larger when the stripe width of the electron donor layer and the stripe width of the electron acceptor layer are not the same.

In the photoelectric conversion device of the present invention, the terms "an electron donor layer having an interdigitated shape in cross section" and "an electron acceptor layer having an interdigitated shape in cross section" are joined so that the mutual comb teeth are engaged with each other.
In this specification, the layer in which "an electron donor layer having an interdigitated shape in cross section" and "an electron acceptor layer having an interdigitated shape in cross section" are joined is referred to as "an electron donor/acceptor junction layer".

According to the present invention having the structure stated above, it is possible to provide a photoelectric conversion device which exhibits excellent charge separation and photoelectric conversion efficiency, with high rectification and suppressed short-circuit, and a method of manufacturing the same.

In this specification, unless otherwise noted, the term "cross section" means the surface that is perpendicular to the electrode main surface.
The term "thickness of an active layer" means a height in cross section of the stripe-like part in cross section of the electron donor layer and the stripe-like part in cross section of the electron acceptor layer.

Preferably, the electron donor layer is composed of an organic semiconductor. More preferably, the electron donor layer is composed of a crystalline organic polymer.
Preferably, the electron acceptor layer is composed of an organic semiconductor. More preferably, the electron acceptor layer is composed of a crystalline organic polymer.
The electron donor layer and the electron acceptor layer may include unavoidable impurities.
Preferably, each thickness of the base of the electron donor layer and the base of the electron acceptor layer is 5 nm or larger and 100 nm or smaller.

The photoelectric conversion device according to the present invention may include a semiconductor layer and/or a conductor layer between the base of the electron donor layer and one of the electrodes and/or between the base of the electron acceptor layer and the other one of the electrodes.

A method of manufacturing a first photoelectric conversion device according to the present invention is a method of manufacturing the photoelectric conversion device according to the present invention stated above including the electron donor layer composed of an organic semiconductor, the method including forming a flat film composed of a material of the electron donor layer and pressing a mold having a reverse pattern corresponding to a pattern of the interdigitated shape in cross section of the electron donor layer to the flat film under a temperature within the range of from Tₘ-100(°C) or more and less than Tₘ(°C), where Tₘ(°C) denotes a melting point of the material forming the electron donor layer, to form the flat film into the pattern of the interdigitated shape in cross section.

A method of manufacturing a second photoelectric conversion device according to the present invention is a method of manufacturing the photoelectric conversion device according to the present invention stated above including the electron acceptor layer composed of an organic semiconductor, the method including forming a flat film composed of a material of the electron acceptor layer and pressing a mold having a reverse pattern corresponding to a pattern of the interdigitated shape in cross section of the electron acceptor layer to the flat film under a temperature within the range of from Tₘ-100(°C) or more and less than Tₘ(°C), where Tₘ(°C) denotes a melting point of the material forming the electron acceptor layer, to form the flat film into the pattern of the interdigitated shape in cross section.

According to the manufacturing method of the first and second photoelectric conversion devices, it is possible to provide a photoelectric conversion device which exhibits excellent charge separation and photoelectric conversion efficiency, with electron donor/acceptor junction layer having excellent pattern accuracy with high uniformity.
The present inventors have found that, according to the manufacturing method of the first and second photoelectric conversion devices of the present invention, a shear force is generated between the organic material forming the electron donor layer or the electron acceptor layer and each wall surface of the reverse pattern corresponding to the pattern of the interdigitated shape in cross section of the electron donor layer or the electron acceptor layer of the mold, and the molecular chain of the organic material tends to be aligned in parallel or substantially parallel to the wall surface of the reverse pattern of the mold.
Orientation of the molecular chain of the organic material in parallel or substantially parallel to the wall surface of the reverse pattern of the mold causes large carrier mobility and small resistance to reach the electrode, which makes it possible to obtain a photoelectric conversion device which exhibits high photoelectric conversion efficiency.

### Advantageous Effects of Invention

According to the present invention, it is possible to provide a photoelectric conversion device which exhibits excellent charge separation and photoelectric conversion efficiency, with high rectification and suppressed short-circuit, and a method of manufacturing the same.

### Brief Description of Drawings

Fig. 1 is a schematic cross-sectional view of a photoelectric conversion device according to one exemplary embodiment;
Fig. 2 is a partially enlarged cross-sectional view of the photoelectric conversion device shown in Fig. 1;
Fig. 3A is a view showing an example of a plane pattern of an active layer (cross-sectional view taken along the line III-III of Fig. 1);
Fig. 3B is a view showing an example of another plane pattern of the active layer (cross-sectional view taken along the line III-III of Fig. 1);
Fig. 3C is a view showing an example of another plane pattern of the active layer (cross-sectional view taken along the line III-III of Fig. 1); and
Fig. 4 is a view showing an example of design modification.

### Description of Embodiments

While an exemplary embodiment of the present invention will be described with reference to the accompanying drawings, the present invention is not limited to the following exemplary embodiment.

Figs. 1, 2, and 3A to 3C are views schematically describing a structure of a photoelectric conversion device according to one exemplary embodiment of the present invention.

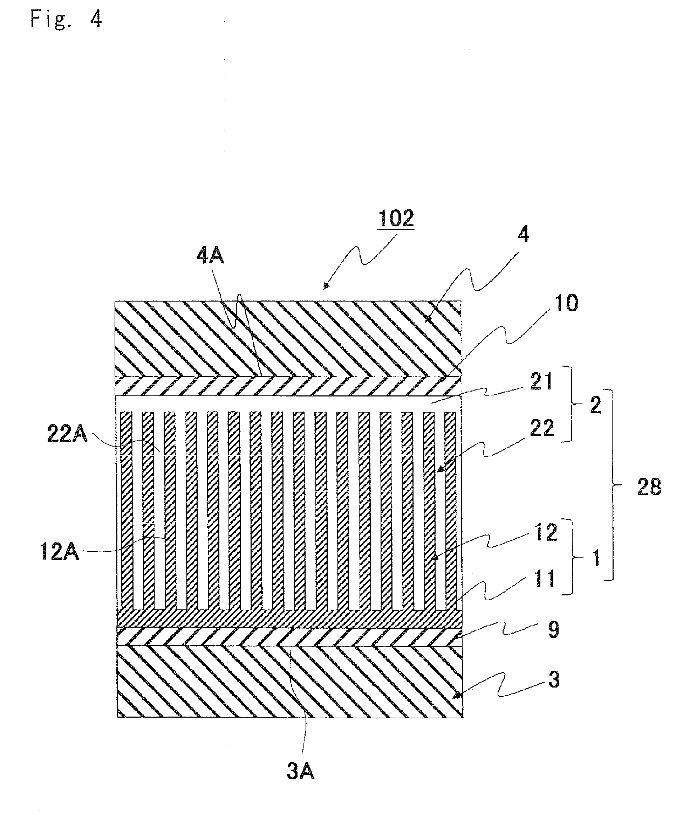

Fig. 1 is a schematic cross-sectional view of the photoelectric conversion device according to the exemplary embodiment. Fig. 2 is a partially enlarged cross-sectional view of the photoelectric conversion device in Fig. 1. Figs. 3A to 3C are views showing examples of plane patterns of an active layer having a structure of interdigitated shape in cross section (cross-sectional views taken along the line III-III of Fig. 1). Fig. 4 is a view showing an example of design modification.

As shown in Fig. 1, a photoelectric conversion device 101 according to the exemplary embodiment includes a pair of electrodes 3 and 4 having main surfaces opposed each other, and an electron donor layer 1 (p layer) having an interdigitated shape in cross section and an electron acceptor layer 2 (n layer) having an interdigitated shape in cross section formed between the pair of electrodes 3 and 4.
The electron donor layer I having an interdigitated shape in cross section and the electron acceptor layer 2 having an interdigitated shape in cross section are joined so that the mutual comb teeth are engaged with each other. The layer in which the electron donor layer 1 having an interdigitated shape in cross section and the electron acceptor layer 2 having an interdigitated shape in cross section are joined while being engaged with each other is an electron donor/acceptor junction layer 28.

In Fig. 1, the electrode main surface of one electrode 3 (the electrode in the lower side of Fig. 1) is denoted by the symbol 3A, and the electrode main surface of the other electrode 4 (the electrode in the upper side of Fig. 1) is denoted by the symbol 4A.
In the exemplary embodiment, one electrode 3 is formed on a substrate which is not shown. In the photoelectric conversion device 101 according to the exemplary embodiment, the electron donor/acceptor junction layer 28 is formed on an electrode substrate in which one electrode 3 is formed, and the other electrode 4 is formed thereon.
The other electrode 4, the electron donor/acceptor junction layer 28, and one electrode 3 may be formed on the substrate in this order.
The electrode main surfaces 3A and 4A of the electrodes 3 and 4 are surfaces parallel to the substrate surface.
Any kind of substate may be used as the substrate. Although it is preferable to use a substrate in terms of manufacturing of the photoelectric conversion device 101, it is not necessary to use a substrate.

The electron donor layer 1 includes a stripe-like part in cross section 12 and a base 11. In the stripe-like part in cross section 12, a plurality of strip-like parts in cross section 12A extending in a direction intersecting, preferably in a direction in a substantially perpendicular to the electrode main surface 3A are formed at predetermined pitches. The base 11 is formed on the side of one electrode 3 of the stripe-like part in cross section 12, and connects the plurality of strip-like parts in cross section 12A.
The electron acceptor layer 2 includes a stripe-like part in cross section 22 and a base 21. In the stripe-like part in cross section 22, a plurality of strip-like parts in cross section 22A extending in a direction intersecting, preferably in a direction in a substantially perpendicular to the electrode main surface 4A are formed at predetermined pitches. The base 21 is formed on the side of the other electrode 4 of the stripe-like part in cross section 22, and connects the plurality of strip-like parts in cross section 22A.

In this specification, the plurality of strip-like parts in cross section 12A of the electron donor layer 1 and the plurality of strip-like parts in cross section 22A of the electron acceptor layer 2 extend substantially perpendicular to the electrode main surfaces 3A and 4A.
In this specification, the term "substantially perpendicular direction" means the complete perpendicular direction and an angle direction of ±5° from the complete perpendicular direction.

As described above, the electron donor layer 1 having an interdigitated shape in cross section and the electron acceptor layer 2 having an interdigitated shape in cross section are joined so that the mutual comb teeth are engaged with each other, and the plurality of strip-like parts in cross section 12A of the electron donor layer 1 and the plurality of strip-like parts in cross section 22A of the electron acceptor layer 2 are alternately joined.

As shown in Fig. 2 in the enlarged view, a junction interface 5 is formed for each of a stripe width of the stripe-like part in cross section 12 (= width of the strip-like part in cross section 12A) a of the electron donor layer 1 and a stripe width of the stripe-like part in cross section 22 (= width of the strip-like part in cross section 22A) b of the electron acceptor layer 2.
The junction interface (p/n junction interface) between the electron donor layer (p layer) 1 and the electron acceptor layer (n layer) 2 which contribute to charge separation includes a junction interface 6 between the stripe-like part 12 of the electron donor layer 1 and the base 21 of the electron acceptor layer 2, and a junction interface 7 between the stripe-like part 22 of the electron acceptor layer 2 and the base 11 of the electron donor layer 1 in addition to the junction interface 5 formed between the stripe-like part 12 of the electron donor layer 1 and the stripe-like part 22 of the electron acceptor layer 2.
Among the above-mentioned junction interfaces, the junction interface 5 has the largest charge separation interfacial area, and the part in which the plurality of strip-like parts in cross section 12A of the electron donor layer 1 and the plurality of strip-like parts in cross section 22A of the electron acceptor layer 2 are alternately joined is an active layer 8.
In Fig. 2, the thickness of the active layer 8 (height in cross section of the stripe-like part in cross section 12 of the electron donor layer 1 and the stripe-like part in cross section 22 of the electron acceptor layer 2) is denoted by the symbol c.
In Fig. 2, the thickness of the base 11 of the electron donor layer 1 is denoted by the symbol d, and the thickness of the base 21 of the electron acceptor layer 2 is denoted by the symbol e.

In this specification, the base 11 of the electron donor layer 1 and one electrode 3 are joined, and the base 21 of the electron acceptor layer 2 and the other electrode 4 are joined.
Accordingly, in the exemplary embodiment, the active layer 8 and the pair of electrodes 3 and 4 are not directly joined, but the active layer 8 is joined with the pair of electrodes 3 and 4 through the bases 11 and 21. According to such a structure, an device with high rectification and suppressed short-circuit can be obtained compared to the patent literatures 1 to 3 listed in the item of "Background Art".
A semiconductor layer and/or a conductor layer may be arranged between the base 11 of the electron donor layer 1 and one electrode 3, and/or the base 21 of the electron acceptor layer 2 and the other electrode 4. Such a design modification will be described later.

Preferably, the stripe width a of the stripe-like part in cross section 12 of the electron donor layer 1 and the stripe width b of the stripe-like part in cross section 22 of the electron acceptor layer 2 are both twice or less as large as the exciton diffusion length in order to increase exciton which contributes to charge separation. It is generally considered that the diffusion length of the exciton of the organic semiconductor is 50 nm or smaller. Further, it is difficult to manufacture the electron donor layer 1 having the stripe width a which is less than 5 nm and the electron acceptor layer 2 having the stripe width b which is less than 5 nm.
From the reasons stated above, the stripe width a of the electron donor layer 1 and the stripe width b of the electron acceptor layer 2 are both set to 5 nm or larger and 100 nm or smaller.
The stripe width a of the electron donor layer 1 and the stripe width b of the electron acceptor layer 2 may be the same or not.

When the stripe width a of the electron donor layer 1 and the stripe width b of the electron acceptor layer 2 are the same, the thickness c of the active layer 8 is twice or more and 40 times or less, more preferably, five times or more and 20 times or less of these stripe widths a and b.
When the stripe width a of the electron donor layer 1 and the stripe width b of the electron acceptor layer 2 are not the same, the thickness c of the active layer 8 is twice or more, preferably five times or more of one of the stripe width a of the electron donor layer 1 and the stripe width b of the electron acceptor layer 2 which is smaller, and 40 times or less, preferably 20 times or less of one of the stripe width a of the electron donor layer 1 and the stripe width b of the electron acceptor layer 2 which is larger.
When the thickness c of the active layer 8 is less than the lower limit value stated above, light absorption is insufficient, and an increase in the charge separation interfacial area is small. When the thickness c of the active layer 8 exceeds the upper limit value stated above, it is difficult to manufacture such active layer 8.
The thickness c of the active layer 8 is preferably within 2 to 40 times, and more preferably within 5 to 20 times of the stripe width a of the electron donor layer 1.

The thickness d of the base 11 of the electron donor layer 1 is not particularly limited. Preferably, the thickness d is 5 nm or larger and 100 nm or smaller similarly to the stripe width a of the electron donor layer 1. More specifically, the thickness d is 5 nm or larger and 50 nm or smaller. Since the junction interface 7 is the charge separation interface, the base 11 of the electron donor layer 1 preferably has the thickness that is close to the diffusion length of the exciton. In the structure of the exemplary embodiment in which the base 11 of the electron donor layer 1 and one electrode 3 are joined, the base 11 of the electron donor layer 1 preferably has a sufficient thickness (specifically 5 nm or larger) in order to avoid short-circuit and adverse effect on the rectification. When the thickness of the base 11 of the electron donor layer 1 is insufficient in the structure of the exemplary embodiment in which the base 11 of the electron donor layer 1 and one electrode 3 are joined, the electron acceptor layer 2 becomes too close to one electrode 3, which may cause degradation of rectification or short-circuit. It is also difficult to make the thickness d smaller than 5 nm.
Further, when the thickness d is larger than 100 nm, resistance with respect to the carrier movement after charge separation increases, which may decrease carrier collection efficiency in the electrode.

The thickness e of the base 21 of the electron acceptor layer 2 is not particularly limited. Preferably, the thickness is 5 nm or larger and 100 nm or smaller similarly to the stripe width b of the electron acceptor layer 2, as is similar to the thickness d of the base 11 of the electron donor layer 1. More preferably, the thickness e is 5 nm or larger and 50 nm or smaller.
In the structure of the exemplary embodiment in which the base 21 of the electron acceptor layer 2 and the other electrode 4 are joined, the base 21 of the electron acceptor layer 2 preferably has a sufficient thickness (specifically 5 nm or larger) in order to avoid short-circuit and adverse effect on the rectification. When the thickness of the base 21 of the electron acceptor layer 2 is insufficient in the structure of the exemplary embodiment in which the base 21 of the electron acceptor layer 2 and the other electrode 4 are joined, the electron donor layer 1 becomes too close to the other electrode 4, which may cause short-circuit and degradation of rectification. It is also difficult to make the thickness e less than 5 nm in terms of the manufacturing process.
Further, when the thickness e is larger than 100 nm, resistance with respect to carrier movement after charge separation becomes large, which may decrease carrier collection efficiency in the electrode.

The thickness of the electron donor/acceptor junction layer 28 (= total film thickness of the active layer 8, the base 11 of the electron donor layer 1, and the base 21 of the electron acceptor layer 2) is not particularly limited. Preferably, the thickness is within the range from 20 nm to 4200 nm. More preferably, the thickness is within the range from 100 nm to 1000 nm. When the thickness of the electron donor/acceptor junction layer 28 is less than 100 nm, the absorption amount may be insufficient. When the thickness exceeds 1000 nm, it may be difficult to manufacture the electron donor/acceptor junction layer 28.

With reference to Figs. 3A to 3C, examples of plane patterns of the active layer 8 will be described. Figs. 3A to 3C are cross-sectional views taken along the line III-III of Fig. 1.

The plane pattern of the active layer 8 shown in Fig. 3A is an example in which both of the electron donor layer 1 and the electron acceptor layer 2 are formed in pattern to have a stripe shape in planar view.

The plane pattern of the active layer 8 shown in Fig. 3B is an example in which the electron acceptor layer 2 is formed in pattern to have a lattice shape in planar view, and the electron donor layer 1 is formed in matrix in planar view.
In the example shown in Fig. 3B, the planar shape of each of the strip-like parts in cross section 12A of the electron donor layer 1 is a rectangular shape. The planar shape of each of the strip-like parts in cross section 12A of the electron donor layer 1 may be any shape including a precise circle shape or an elliptical shape.

The plane pattern of the active layer 8 shown in Fig. 3C is an example in which the electron donor layer 1 is formed in pattern to have a lattice shape in planar view, and the electron acceptor layer 2 is formed in matrix in planar view.
In the example shown in Fig. 3C, the planar shape of each of the strip-like parts in cross section 22A of the electron acceptor layer 2 is a rectangular shape. The planar shape of each of the strip-like parts in cross section 22A of the electron acceptor layer 2 may have any shape including a precise circle shape or an elliptical shape.

In the photoelectric conversion device 101, the material of the electrodes 3 and 4 is not particularly limited as long as it is a conductor, and may be a single metal, an alloy, a semimetal, a metallic compound, an organic conductor, or the like. They may include a dopant. It is required that at least one electrode is a transparent electrode.
The material of the electrodes 3 and 4 may include a single metal of gold, silver, platinum, aluminium or the like and an alloy thereof, a metal oxide (e.g., indium tin oxide (ITO), fluorine doped tin oxide (FTO), and aluminium doped zinc oxide (AZO)), and a semimetal (e.g., carbon nanotube, graphene).

The thickness of the electrodes 3 and 4 is not particularly limited. Preferably, the thickness is 5 to 200 nm. When the film thickness of the electrodes 3 and 4 is too small, the sheet resistance becomes large, which makes it impossible to sufficiently transmit the carrier that is generated to an external circuit. When the film thickness of the electrodes 3 and 4 is too large, it is difficult to manufacture the electrodes and the cost increases.

The method of forming the electrodes 3 and 4 is not particularly limited. For example, they may be made by a vapor phase film forming method (e.g., a vacuum evaporation method, a sputtering method, and a CVD method), or by a liquid phase film forming method (e.g., a spin coating method, a dip coating method, and a screen printing method).

The material of the electron donor layer 1 is not particularly limited. Preferably, an organic semiconductor is used. More preferably, a crystalline organic polymer is used.
The material of the electron donor layer 1 may include a polymer compound (e.g., a polythiophene derivative, a polyfluorene derivative, and a polyphenylene vinylene derivative) and a copolymer thereof, or a phthalocyanine derivative and a metal complex thereof, a porphyrin derivative and a metal complex thereof, an acene derivative including pentacene, and a low molecular weight compound including a diamine derivative. Preferably, the material of the electron donor layer 1 is poly (3-(2-methylhexane) oxycarbonyldithiophene), 3-(6-bromohexyl) thiophene·3-hexylthiophenecopolymer or the like.
The electron donor layer 1 may also include unavoidable impurities.

The material of the electron acceptor layer 2 is not particularly limited. Preferably, an organic semiconductor is used. More preferably, a crystalline organic polymer is used.
The material of the electron acceptor layer 2 may include a fullerene derivative, a perylene derivative, and a naphthalene derivative. Preferably, the material of the electron acceptor layer 2 is phenyl C61 butyrate methyl ester, phenyl C71 butyrate methyl ester or the like.

As shown in Fig. 4, a semiconductor layer and/or a conductor layer may be arranged between the base 11 of the electron donor layer 1 and one electrode 3, and/or the base 21 of the electron acceptor layer 2 and the other electrode 4. Hereinafter, the semiconductor layer and/or the conductor layer are denoted by a (semi) conductor layer.
A photoelectric conversion device 102 shown in Fig. 4 is an example in which a (semi) conductor layer 9 is arranged between the base 11 of the electron donor layer 1 and one electrode 3, and a (semi) conductor layer 10 is arranged between the base 21 of the electron acceptor layer 2 and the other electrode 4. Each of the (semi) conductor layers 9 and 10 may be a laminated layer of a plurality of (semi) conductor layers having different compositions.

The material of the (semi) conductor layers 9 and 10 is not particularly limited. For example, the material may include a polymer compound (e.g., poly-3,4-ethylenedioxythiophene, polystyrene sulfonic acid, and polyaniline), a semimetal including carbon nanotube, a metallic compound (e.g., titanium oxide, molybdenum oxide, and lithium fluoride), or an alloy (e.g., an aluminium alloy and a magnesium alloy).

The method of forming the (semi) conductor layers 9 and 10 is not particularly limited. For example, the method may include a vapor phase film forming method (e.g., a vacuum evaporation method, a sputtering method, and a CVD method), or a liquid phase film forming method (e.g., a spin coating method, a dip coating method, and a screen printing method).

The manufacturing method of the photoelectric conversion devices 101 and 102 shown in Figs. 1 and 4 is not particularly limited.
When the electron donor layer 1 is composed of an organic semiconductor, the photoelectric conversion devices 101 and 102 may be manufactured by a nanoimprinting method as follows, for example.
A flat film composed of the material of the electron donor layer 1 is formed on the substrate in which one electrode 3 or one electrode 3 and the (semi) conductor layer 9 are formed. A mold having a reverse pattern corresponding to the pattern of the interdigitated shape in cross section of the electron donor layer 1 and the plane patterns as shown in Figs. 3A to 3C is pressed to the flat film under a temperature within the range of from Tₘ-100(°C) or more and less than Tₘ(°C), where Tₘ(°C) denotes a melting point of the material forming the electron donor layer 1, to transfer the pattern of the mold. This makes it possible to form the flat film into the pattern of the interdigitated shape in cross section.
After the temperature of the electron donor layer 1 is lowered and the electron donor layer 1 is solidified, the electron acceptor layer 2 is formed along the pattern having the interdigitated shape in cross section of the electron donor layer 1 on the electron donor layer 1 so as not to destroy the structure of the interdigitated shape in cross section, thereby being able to form the electron donor/acceptor junction layer 28 having a structure of interdigitated shape in cross section.
Then, the (semi) conductor layer 10 is formed on the electron donor/acceptor junction layer 28 as necessary, and the other electrode 4 is formed, thereby manufacturing the photoelectric conversion device 101 or 102.

The method of forming the flat film which is the electron donor layer 1 and the electron acceptor layer 2 is not particularly limited, and may include, for example, a vapor phase film forming method (e.g., a vacuum evaporation method and a sputtering method), or a liquid phase film forming method (e.g., a spin coating method, a dip coating method, and a spray coating method).
Film forming conditions or film forming methods of the flat film which is the electron donor layer 1 and the electron acceptor layer 2 may be changed. For example, the electron donor layer 1 and the electron acceptor layer 2 may be formed by a plurality of stages.

The above mold is composed of silicon, glass, and metal, on which surface having a irregular pattern corresponding to the structure of interdigitated shape in cross section of the electron donor layer 1. The method of manufacturing such a mold is not particularly limited. For example, the method may include a method of forming a resist pattern by electron beam lithography on a thermal oxidation silicon substrate to perform dry etching on the substrate using the resist pattern as a mask, a method of forming a resist pattern by electron beam lithography on a Cr sputter quartz glass substrate to perform dry etching on the substrate using the resist pattern as a mask, and a method of forming a resist pattern by electron beam lithography on a silicon substrate to perform wet etching on the substrate using the resist pattern as a mask.

According to the manufacturing method stated above, it is possible to manufacture the photoelectric conversion device 101 or 102 which exhibits excellent charge separation and high photoelectric conversion efficiency, with electron donor/acceptor junction layer 28 having excellent pattern accuracy with high uniformity.

When the electron acceptor layer 2 is composed of an organic semiconductor, the photoelectric conversion devices 101 and 102 may be formed from the side of the other electrode 4.
A flat film composed of the material of the electron acceptor layer 2 is formed on the substrate in which the other electrode 4 or the other electrode 4 and the (semi) conductor layer 10 are formed. A mold having a reverse pattern corresponding to the pattern of the interdigitated shape in cross section of the electron acceptor layer 2 and the plane patterns as shown in Figs. 3A to 3C is pressed to the flat film under a temperature within the range of from Tₘ-100(°C) or more and less than Tₘ(°C), where Tₘ(°C) denotes a melting point of the material forming the electron acceptor layer 2, to transfer the pattern of the mold. In this way, the flat film can be formed into the pattern having the interdigitated shape in cross section.
After the temperature of the electron acceptor layer 2 is lowered and the electron acceptor layer 2 is solidified, the electron donor layer 1 is formed along the pattern having the interdigitated shape in cross section of the electron acceptor layer 2 on the electron acceptor layer 2 so as not to destroy the structure of the interdigitated shape in cross section, thereby capable of forming the electron donor/acceptor junction layer 28 having a structure of interdigitated shape in cross section.
Then, by forming the (semi) conductor layer 9 on the electron donor/acceptor junction layer 28 as necessary and forming one electrode 3, the photoelectric conversion device 101 or 102 is manufactured.
The method of forming the flat film which is the electron acceptor layer 2 and the electron donor layer 1 is similar to the case in which the photoelectric conversion device 101 or 102 is formed from the side of one electrode 3.
According to this manufacturing process as well, it is possible to manufacture the photoelectric conversion device 101 or 102 which exhibits excellent charge separation and high photoelectric conversion efficiency, with electron donor/acceptor junction layer 28 having excellent pattern accuracy with high uniformity.

The present inventors have found that, according to the manufacturing method described above including the forming step by the nanoimprinting method, a shear force is generated between the organic material forming the electron donor layer 1 or the electron acceptor layer 2 and each wall surface of the reverse pattern corresponding to the pattern of the interdigitated shape in cross section of the electron donor layer 1 or the electron acceptor layer 2 in the mold, and the molecular chain of the organic material tends to align in parallel or substantially parallel to the wall surface of the reverse pattern of the mold.
Orientation of the molecular chain of the organic material in parallel or substantially parallel to the wall surface of the reverse pattern of the mold causes large carrier mobility and small resistance to reach the electrode, which makes it possible to obtain a photoelectric conversion device which exhibits high photoelectric conversion efficiency.
In particular, the electron donor layer 1 composed of crystalline polymer is preferably used because it causes excellent orientation of the polymer. In the similar way, the electron acceptor layer 2 composed of crystalline polymer is also preferably used because it cases excellent orientation of the polymer.

As described above, the photoelectric conversion devices 101 and 102 according to the exemplary embodiment are devices including the electron donor/acceptor junction layer 28 between the pair of electrodes 3 and 4. In the electron donor/acceptor junction layer 28, the electron donor layer 1 having an interdigitated shape in cross section and the electron acceptor layer 2 having an interdigitated shape in cross section are joined.
In the photoelectric conversion devices 101 and 102, the active layer 8 and the pair of electrodes 3 and 4 are not directly joined, but the active layer 8 is joined with the pair of electrodes 3 and 4 through the bases 11 and 21, or the bases 11 and 21 and the (semi) conductor layers 9 and 10.
In the photoelectric conversion devices 101 and 102, both of the stripe width a of the electron donor layer 1 and the stripe width b of the electron acceptor layer 2 are 5 nm or larger and 100 nm or smaller.
Further, when the stripe width a of the electron donor layer 1 and the stripe width b of the electron acceptor layer 2 are the same, the thickness c of the active layer 8 is twice or more and 40 times or less of the stripe widths a and b.
When the stripe width a of the electron donor layer 1 and the stripe width b of the electron acceptor layer 2 are not the same, the thickness c of the active layer 8 is twice or more of one of the stripe width a of the electron donor layer 1 and the stripe width b of the electron acceptor layer 2 which is smaller and 40 times or less of one of the stripe width a of the electron donor layer 1 and the stripe width b of the electron acceptor layer 2 which is larger.
According to the exemplary embodiment having the aforementioned structure, it is possible to provide photoelectric conversion devices 101 and 102 which exhibit excellent charge separation and high photoelectric conversion efficiency, with high rectification and suppressed short-circuit.

### [Examples]

While the present invention will be described in detail based on examples, the present invention is not limited to these examples.

In the following examples, the photoelectric conversion device 101 having the structure shown in Figs. 1, 2, and 3A, or the photoelectric conversion device 102 having the structure shown in Figs. 2, 3A, and 4 was manufactured.
The stripe width a of the electron donor layer 1 is 100 nm, the stripe width b of the electron acceptor layer 2 is 100 nm, the thickness c of the active layer 8 is 500 nm, the thickness d of the base 11 of the electron donor layer 1 is 50 nm, and the thickness e of the base 21 of the electron acceptor layer 2 is 50 nm.
The mold used for forming the pattern of the electron donor layer 1 includes a plurality of trenches each having a width of 100 nm, a length of 6 mm, and a depth of 500 nm, and the pitch of the trenches is 200 nm. The area in plane view of the part in which the structure of interdigitated shape in cross section of the mold is formed is 6 mm × 6 mm.

The conversion efficiency measurement of the photoelectric conversion device was performed using a solar simulator. The conversion efficiency was calculated by radiating artificial sunlight (AM1.5G, 1kW/m²) using a xenon lamp (500 W) and measuring an I-V curve.

### [Example 1]

Poly (3-(2-methylhexane) oxycarbonyldithiophene) was formed on an electrode substrate having a thickness of 0.7 mm, on which surface an ITO transparent electrode having a film thickness of 100 nm was formed, to have a thickness of 300 nm by a spin coating method. After heat treatment was performed under a predetermined temperature, the film was applied with pressure using the mold under the conditions of 180°C and 40MPa, thereby forming an electron donor layer having a=100 nm, c=500 nm, and d=50 nm. Further, after heat treatment was performed under a predetermined temperature, phenyl C61 butyrate methyl ester (PCBM)-chlorobenzene solution was spin-coated to form the electron acceptor layer having b=100 nm, c=500 nm, and e=50 nm. After that, Al was vacuum-deposited with a film thickness of 100 nm to obtain the device. The conversion efficiency that was measured was 3.1%.

### [Example 2]

Poly (3,4-ethylenedioxythiophene): polystyrene sulfonic acid (PEDOT: PSS) aqueous solution was spin-coated on an electrode substrate having a thickness of 0.7 mm, on which surface an ITO transparent electrode having a film thickness of 100 nm was formed, to form PEDOT: PSS film with a film thickness of 30 nm. This film was dried under 110°C for one hour, thereafter poly (3-(2-methylhexane) oxycarbonyldithiophene) was spin-coated with a thickness of 300 nm-After heat treatment was performed under a predetermined temperature, this film was applied with pressure using the mold under the conditions of 180°C and 40MPa, thereby forming the electron donor layer with a=100 nm, c=500 nm, and d=50 nm. Further, after heat treatment was performed under a predetermined temperature, PCBM-chlorobenzene solution was spin-coated to form the electron acceptor layer with b=100 nm, c=500 nm, and e=50 nm. After that, titanium propoxide solution was spin-coated with a film thickness of 10 nm, which is then dried. Then, Al was vacuum-deposited with a film thickness of 100 nm, thereby obtaining an element. The conversion efficiency that was measured was 3.8%.

### [Example 3]

Poly (3,4-ethylenedioxythiophene): polystyrene sulfonic acid (PEDOT: PSS) aqueous solution was spin-coated on an electrode substrate having a thickness of 0.7 mm, on which surface an ITO transparent electrode having a film thickness of 100 nm was formed, to form PEDOT: PSS film with a film thickness of 30 nm. This film was dried under a temperature of 110°C for one hour, thereafter poly (3-hexylthiophene) (P3HT) was spin-coated with a thickness of 300 nm. After heat treatment was performed under a predetermined temperature, the film was heated under the conditions of 180°C and 40MPa using the mold, thereby forming the electron donor layer with a=100 nm, c=500 nm, and d=50 nm.
Further, after heat treatment was performed under a predetermined temperature, oblique light incidence X-ray diffraction measurement was performed. The (100) surface separation of the P3HT main chain, and the peak of 20=5.4° were particularly noted. An OUT-PLANE (OP) measurement in which X rays are radiated from the surface parallel to the substrate surface, and an IN-PLANE (IP) measurement in which X rays are radiated from the surface perpendicular to the substrate surface were performed.
A small peak with a strength of about 500 was obtained in the OP measurement, and a large peak with a strength of about 2250 was obtained in the IP measurement. From these results, many P3HT main chains are considered to be oriented in the direction substantially perpendicular to the ITO substrate surface.

### [Comparative example 1]

Poly (3,4-cthylenedioxythiophene): polystyrene sulfonic acid (PEDOT: PSS) aqueous solution was spin-coated on an electrode substrate having a thickness of 0.7 mm, on which surface an ITO transparent electrode having a film thickness of 100 nm was formed, to form PEDOT: PSS film with a film thickness of 30 nm. This film was dried under a temperature of 110°C for one hour, thereafter poly (3-(2-methylhexane) oxycarbonyldithiophene) was spin-coated with a thickness of 300 nm. After heat treatment was performed under a predetermined temperature, PCBM-chlorobenzen.e solution was spin-coated to form an electron acceptor layer with a film thickness of 300 nm. After that, titanium propoxide solution was spin-coated with a film thickness of 10 nm, thereafter this was dried. Then, Al was vacuum-deposited with a film thickness of 100 nm, thereby obtaining an element. The conversion efficiency that was measured was 0.7%.

### [Comparative example 2]

Poly (3,4-ethylenedioxythiophene): polystyrene sulfonic acid (PEDOT: PSS) aqueous solution was spin-coated on an electrode substrate having a thickness of 0.7 mm, on which surface an ITO transparent electrode having a film thickness of 100 nm was formed, to form PEDOT: PSS film with a film thickness of 30 nm. This film was dried under a temperature of 110°C for one hour, thereafter chloroform solution in which poly (3-(2-methylhexane) oxycarbonyldithiophene) and PCBM are mixed with the rate of 0.9:1 was spin-coated so that the film has a thickness of 600 nm. After heat treatment was performed under a predetermined temperature, titanium propoxide solution was spin-coated with a film thickness of 10 nm, thereafter this was dried. Then, Al was vacuum-deposited with a film thickness of 100 nm, thereby obtaining an element The conversion efficiency that was measured was 1.9%.

### [Comparative example 3]

Poly (3,4-ethylenedioxythiophene): polystyrene sulfonic acid (PEDOT: PSS) aqueous solution was spin-coated on an electrode substrate having a thickness of 0.7 mm, on which surface an ITO transparent electrode having a film thickness of 100 nm was formed, to form PEDOT: PSS film with a film thickness of 30 nm. This film was dried under a temperature of 110°C for one hour, and then poly (3-(2-methylhexane) oxycarbonyldithiophene) was spin-coated with a thickness of 300 nm. After heat treatment was performed under a predetermined temperature, the film was applied with pressure using the mold under the conditions of 80°C and 5MPa, thereby forming the electron donor layer (c= 5 nm) with little irregularities. Further, after heat treatment was performed under a predetermined temperature, PCBM-chlorobenzene solution was spin-coated to form an electron acceptor layer with a film thickness of 300 nm. After that, titanium propoxide solution was spin-coated with a film thickness of 10 nm, thereafter this was dried. Then, Al was vacuum-deposited with a film thickness of 100 nm, thereby obtaining an element. The conversion efficiency that was measured was 0.7%.

### [Comparative example 4]

Poly (3,4-ethylenedioxythiophene): polystyrene sulfonic acid (PEDOT: PSS) aqueous solution was spin-coated on an electrode substrate having a thickness of 0.7 mm, on which surface an ITO transparent electrode having a film thickness of 100 nm was formed, to form PEDOT: PSS film with a film thickness of 30 nm. This film was dried under a temperature of 110°C for one hour, thereafter poly (3-hexylthiophene) (P3HT) was spin-coated with a thickness of 300 nm.
After heat treatment was performed under a predetermined temperature, oblique light incidence X-ray diffraction measurement was performed. The (100) surface separation of the P3HT main chain, and the peak of 20=5.4° were particularly noted. The OP measurement and the IP measurement were performed as is similar to the example 3. A large peak with the strength of about 20000 was obtained in the OP measurement, and a small peak with the strength of about 100 was obtained in the IP measurement. From these result, most of the P3HT main chain are considered to be oriented in the direction parallel to the ITO substrate surface.

The present invention is not limited to the above exemplary embodiment. Any change, addition, or modification that can be easily conceived by a person skilled in the art may be made to each element of the exemplary embodiment stated above within the scope of the present invention.

This application claims the benefit of priority, and incorporates herein by reference in its entirety, the following Japanese Patent Application No. 2009-187357 filed on August 12, 2009.

### Industrial Applicability

The photoelectric conversion device according to the present invention may be preferably applied to a solar cell, a light emitting device, a light receiving device, and other various sensors.

### Preference Signs List

- 101, 102: PHOTOELECTRIC CONVERSION DEVICE
- 1: ELECTRON DONOR LAYER
- 2: ELECTRON ACCEPTOR LAYER
- 3, 4: ELECTRODE
- 3A, 4A: ELECTRODE MAIN SURFACE
- 5∼7: P/N JUNCTION INTERFACE
- 8: ACTIVE LAYER
- 9, 10: (SEMI) CONDUCTOR LAYER
- 11: BASE OF ELECTRON DONOR LAYER
- 12: STRIPE-LIKE PART IN CROSS SECTION OF ELECTRON DONOR LAYER
- 12A: STRIP-LIKE PART IN CROSS SECTION
- 21: BASE OF ELECTRON ACCEPTOR LAYER
- 22: STRIPE-LIKE PART IN CROSS SECTION OF ELECTRON ACCEPTOR LAYER
- 22A: STRIP-LIKE PART IN CROSS SECTION
- 28: ELECTRON DONOR/ACCEPTOR JUNCTION LAYER
- a: STRIPE WIDTH OF STRIPE-LIKE PART IN CROSS SECTION OF ELECTRON DONOR LAYER
- b: STRIPE WIDTH OF STRIPE-LIKE PART IN CROSS SECTION OF ELECTRON ACCEPTOR LAYER
- c: THICKNESS OF ACTIVE LAYER

## Claims

1. A photoelectric conversion device comprising, between a pair of electrodes arranged so that electrode main surfaces of the electrodes are opposed to each other,
an electron donor layer having an interdigitated shape in cross section comprising a stripe-like part in cross section and a base, a plurality of strip-like parts in cross section extending in a direction intersecting the electrode main surfaces being formed at intervals in the stripe-like part in cross section, the base formed on a side of one of the electrodes of the stripe-like part in cross section and connecting the plurality of strip-like parts in cross section; and
an electron acceptor layer having an interdigitated shape in cross section comprising a stripe-like part in cross section and a base, a plurality of strip-like parts in cross section extending in a direction intersecting the electrode main surfaces being formed at intervals in the stripe-like part in cross section, the base formed on a side of the other one of the electrodes of the stripe-like part in cross section and connecting the plurality of strip-like parts in cross section,
the photoelectric conversion devices further comprising an active layer in which the plurality of strip-like parts in cross section of the electron donor layer and the plurality of strip-like parts in cross section of the electron acceptor layer are alternately joined, wherein
a stripe width of the stripe-like part in cross section of the electron donor layer and a stripe width of the stripe-like part in cross section of the electron acceptor layer are both 5 nm or larger and 100 nm or smaller,
a thickness of the active layer is twice or more and 40 times or less of the stripe width when the stripe width of the electron donor layer and the stripe width of the electron acceptor layer are the same, and
the thickness of the active layer is twice or more of one of the stripe width of the electron donor layer and the stripe width of the electron acceptor layer which is smaller and 40 times or less of one of the stripe width of the electron donor layer and the stripe width of the electron acceptor layer which is larger when the stripe width of the electron donor layer and the stripe width of the electron acceptor layer are not the same.

2. The photoelectric conversion device according to Claim 1, wherein the electron donor layer is composed of an organic semiconductor.

3. The photoelectric conversion device according to Claim 2, wherein the organic semiconductor is composed of a crystalline organic polymer.

4. The photoelectric conversion device according to any one of Claims 1 to 3, wherein the electron acceptor layer is composed of an organic semiconductor.

5. The photoelectric conversion device according to any one of Claims 1 to 4, wherein each thickness of the base of the electron donor layer and the base of the electron acceptor layer is 5 nm or larger and 100 nm or smaller.

6. The photoelectric conversion device according to any one of Claims 1 to 5, comprising a semiconductor layer and/or a conductor layer between the base of the electron donor layer and one of the electrodes and/or between the base of the electron acceptor layer and the other one of the electrodes.

7. A method of manufacturing the photoelectric conversion device according to Claim 2 or 3, comprising forming a flat film composed of a material of the electron donor layer and pressing a mold having a reverse pattern corresponding to a pattern of the interdigitated shape in cross section of the electron donor layer to the flat film under a temperature within the range of from Tₘ-100(°C) or more and less than Tₘ(°C), where Tₘ(°C) denotes a melting point of the material forming the electron donor layer, to form the flat film into the pattern of the interdigitated shape in cross section.

8. The method of manufacturing the photoelectric conversion device according to Claim 7, further comprising forming the electron acceptor layer on the electron donor layer along the pattern of the interdigitated shape in cross section of the electron donor layer.

9. A method of manufacturing the photoelectric conversion device according to Claim 4, comprising forming a flat film composed of a material of the electron acceptor layer and pressing a mold having a reverse pattern corresponding to a pattern of the interdigitated shape in cross section of the electron acceptor layer to the flat film under a temperature within the range of from Tₘ-100(°C) or more and less than Tₘ(°C), where Tₘ(°C) denotes a melting point of the material forming the electron acceptor layer, to form the flat film into the pattern of the interdigitated shape in cross section.

10. The method of manufacturing the photoelectric conversion device according to Claim 9, further comprising forming the electron donor layer on the electron acceptor layer along the pattern of the interdigitated shape in cross section of the electron acceptor layer.
